# EUROPEAN PATENT SPECIFICATION

(11) **EP 0 587 192 B1**
(45) Date of publication and mention of the grant of the patent: **27.11.1996**
(21) Application number: 93115068.4
(22) Date of filing: 04.07.1989
(51) Int. Cl.: B41J 2/295

(54) **Electro-distortion device**
Elektrische Verformungsvorrichtung
Dispositif électro-déformable

(30) Priority: 08.07.1988 JP 168894/88; 11.11.1988 JP 283897/88
(43) Date of publication of application: 16.03.1994
(62) Divisional of application: 89306778.5
(73) Proprietor: FUJITSU LIMITED, Kawasaki-shi, Kanagawa 211 (JP)
(72) Inventor: Yano, Akio, Tokyo 157 (JP)
(74) Representative: Fenlon, Christine Lesley

(56) References cited:
- PATENT ABSTRACTS OF JAPAN vol. 012, no. 277 (E-640) 30 July 1988 & JP-A-63 056 971 (NIPPON SOKEN INC) 11 March 1988
- PATENT ABSTRACTS OF JAPAN vol. 010, no. 357 (M-540) 2 December 1986 & JP-A-61 153 025 (NIPPON DENSO CO LTD) 11 July 1986
- PATENT ABSTRACTS OF JAPAN vol. 011, no. 110 (E-496) 7 April 1987 & JP-A-61 258 485 (AISAN IND CO LTD) 15 November 1986
- PATENT ABSTRACTS OF JAPAN vol. 011, no. 288 (E-542) 17 September 1987 & JP-A-62 088 382 (NEC CORP) 22 April 1987
- PATENT ABSTRACTS OF JAPAN vol. 005, no. 023 (E-045) 12 February 1981 & JP-A-55 150 284 (NGK SPARK PLUG CO LTD) 22 November 1980
- PATENT ABSTRACTS OF JAPAN vol. 12, no. 218 (M-711) (3065) 22 June 1988 & JP-A-63 017 060 (NEC) 25 January 1988
- PATENT ABSTRACTS OF JAPAN vol. 9, no. 95 (E-310) 24 April 1985 & JP-A-59 222 977 (NIPPON JIDOSHA BUHIN SOGO KENKYUSHO) 14 December 1984

## Description

This invention relates to an electro-distortion device according to the preamble of claim 1 and to a dot-matrix printing head incorporating such a device.

Recently, high-speed wire-dot printing heads have become widely used and, accordingly, in order to drive the dot-impact wires or rods of such high speed printing heads, actuators comprising electro- or magnetic-distortion devices have been developed and used instead of electromagnet type drive elements.

The use of such electro-distortion devices in a printing head has been proposed in "NIKKEI (Japan Economic) MECHANICAL", page 92, March 12, 1984, for example, the proposed electro-distortion device being made by the steps of: preparing a plurality of green sheets made of piezo-electric ceramics, forming a metal paste film on one of the surfaces of each of the green sheets to form an inner electrode, and laminating and sintering the plurality of green sheets.

A printing head using such an actuating device must be provided with means for effectively enlarging the very small displacements of such an actuating element so as to drive the dot-impact wires or rods adequately.

A dot-matrix printing head may include an array of dot-printing devices operable selectively to cause respective dot-defining portions thereof to impinge on a printing medium to cause respective dots to be printed.

JP-A-59-16767 proposes a dot-printing device, suitable for use in such a dot-matrix printing head to achieve such enlargement, which device may be considered to comprise a flexible member, fixed at one end thereof to a support structure of the head and having at its other end the said dot-defining portion of the device, and also to comprise an electrically controllable actuator operable to impose movement on the flexible member, substantially perpendicular to the main plane of that member, at an actuating position thereon so as to bring about such impingement of the dot-defining portion of the device, the flexible member being elongate in form, at least in the region between the said one end and the actuating position, and the distance of the said actuating position from the said one end of the flexible member of the device being small in comparison with the distance of the actuating position from the said dot-defining portion of the device.

A suitable form of dot printing device is proposed in US-4,362,407, which employs an actuator substantially including an electro-distortion device comprising a stack of laminations made of an electro-distortion material with respective electrodes included at different positions in the stack, each of which electrodes is sandwiched between two successive laminations of the electro-distortion material, and externally accessible connection means operable to apply an electrical potential between successive electrodes in the stack, thereby to bring about a bending deflection in the stack, with the deflection being perpendicular to the stacking axis.

A piezoelectric stack is known from JP-A-63 056 971 made up of a plurality of piezoelectric boards. Each board comprises a ceramic sheet of piezoelectric material and an electrode printed thereon. The boards are arranged so that patterns appear in the same position on every other board of the stack. Electro-nickel plating is then applied to the stack and metal projections are formed at the edge of every other electrode on each of the opposing surfaces of the stack. A board is placed on the metal projections and a resin is made to flow thereunder which cures to form an insulating layer. Electrodes are then applied to the insulating layer and form external electrodes.

In such a known electro-distortion device, however, unsatisfactory operation may occur in damp or humid environments.

The above-mentioned problems are solved in a device of the initially named kind by the features of the characterising clause of claim 1.

Reference will now be made, by way of example, to the accompanying drawings, in which:
Figure 1 shows a longitudinal sectional view of an electro-distortion device embodying the present invention;
Figure 2 shows a partial perspective view of a printing head, in which the device of Figure 1 may be employed; and
Figures 3A and 3B show plan and side views respectively of a printing device used in the printing head of Figure 2.

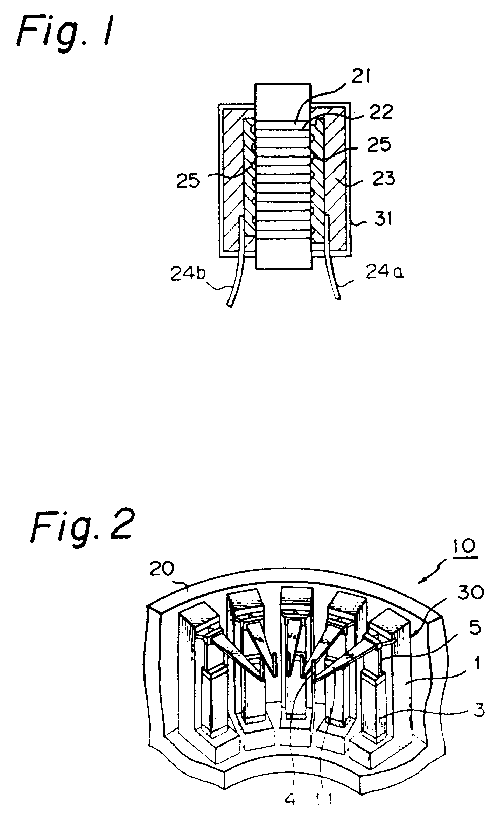

Figure 1 illustrates an electro-distortion device, embodying the present invention, which is suitable for use in an actuator for driving a dot-impact printing wire or rod in a printing head. This electro-distortion device comprises a plurality of sheets 21 which are made of an electro-distortion material such as a piezo-electric ceramic, stacked together with laminate electrodes 22 therebetween. A first group of alternately arranged electrodes 22 are connected to a lead 24a and insulated from the other electrodes 22 by beads 25 which are made of an electrically insulating material, such as glass. The other group of alternate electrodes 22 are connected to a second lead 24b and insulated from the first group of electrodes 22 in the same manner as above. The laminations comprising the sheets of electro-distortion material 21 and the electrodes 22 are enclosed within an insulating resin material 23, such as an epoxy resin.

In use, an operating voltage is applied between the leads 24a and 24b, causing longitudinal electrostrictive expansion or contraction of the stack of laminations.

In the device of Figure 1, the insulating resin material 23 is itself also enveloped in a metal cover 31. This metal cover 31 can be formed by vaporizing an appropriate metal, such as aluminium, onto the insulating resin material 23, thus inhibiting the ingress of moisture into the electro-distortion device by virtue of the high moisture-proof characteristics of such a metal cover. The insulating resin material 23 prevents short-circuits between adjacent electrodes 22 that would otherwise be caused by the metal cover 31. As a result, the groups of electrodes 22 are not prone to becoming electrically connected to each other due to migration effects, for example, even if the device is used in a moist environment, ensuring that the device has a desirably high inherent reliability.

Figure 2 shows a printing head 10 of a dot-impact printer suitable for employing an electro-distortion device embodying the invention as an actuator 3. The printing head 10 comprises a cylindrical housing 20 and a plurality of printing devices 30 arrayed around and extending radially within the cylindrical housing 20.

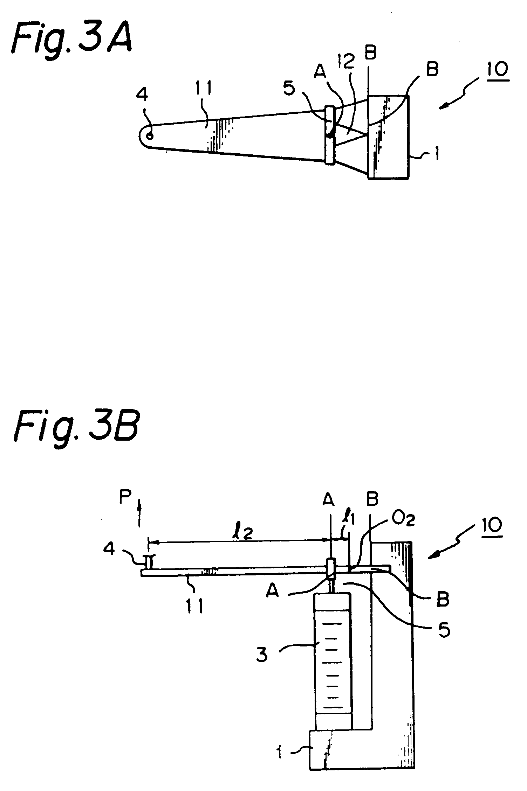

As shown in more detail in Figures 3A and 3B, each of the devices 30 comprises a base member 1, a movable member 11, and an actuator (electro-distortion device) 3. The movable member 11 comprises a flat leaf spring made of an appropriate resilient material having one end rigidly secured to the base member 1 at a fixing position B and a free remote end on which a dot-printing member (dot-printing pin or wire) 4 is mounted. A predetermined number of such dot-printing members 4 cooperate to constitute a dot matrix. As may be seen in the plan view of Figure 3A, the movable member 11 is gradually tapered, along substantially its entire length, from the fixing portion B to the free end thereof.

The actuator 3 has one end (the bottom of the stack of laminations) rigidly secured to the base member 1 and the other end (the top of the stack of laminations) connected via a connecting member 5 to the movable member 11 at an actuating position A thereof. The actuating position A is relatively near to the position B at which the movable member 11 is fixed to the base member 1.

As seen in the plan view of Figure 3A, the region of the laminate movable member 11 that extends from the actuating position A to the fixing position B comprises two substantially triangular portions arranged laterally adjacent to one another, each of the portions having a base at the fixing position B and a truncated apex at the actuating position A. These two lateral portions are separated, as seen in the plan view, by a triangular-form aperture 12, having a base at the actuating position A and an apex at the fixing position B or in the vicinity thereof. In general, at least one such triangular-form aperture is desirable. As shown in the plan view of Figure 3A, the remaining part of the movable member 11 is gradually tapered from the actuating position A to the free end thereof.

When printing, electric power is supplied via a drive circuit (not shown) to the actuator 3 for a predetermined time. This causes the actuator 3 to be distorted in the upward direction (i.e. perpendicular to the flat movable member 11), thereby upwardly displacing the movable member 11 at the actuating position A. The movable member 11 is thus resiliently deformed between the actuating position A and the fixing position B, so that the movable member 11 is bent in a clockwise direction, as shown in Figure 3B, about a centre of rotation (0₂) near to the fixing position B. Owing to this movement of the movable member 11, the dot-printing member 4 is moved upward as shown by on arrow P in Figure 3B to perform a printing operation. The electric power supply to the actuator 3 is stopped just before the completion of the printing operation, and thus, after completion of printing, the movable member 11 is returned to its original position by the actuator 3.

Further details of the printing head described above will be found in European potent application no. 89306778.5, out of which the present application has been divided.

## Claims

1. An electro-distortion device comprising at least first, second and third laminations (21) comprising electro-distortive material, with at least one first electrode (22), the first electrode (22) being interposed between the first lamination and the second lamination, and at least one second electrode (22), the second electrode (22) being interposed between the second lamination and the third lamination (21), the laminations and electrodes being arranged in a stack extending along a stack axis and having a first lateral surface and a second lateral surface, the first and second electrodes being electrically connected to first and second externally accessible connection means (24a, 24b) respectively via the first and second lateral surfaces respectively so that an electrical potential difference applied to the first and second externally accessible connection means (24a, 24b) brings about a change in the extent of the stack along its stacking axis, the first electrode or electrodes and the second electrode or electrodes being electrically insulated from one another via at least a first portion and at least a second portion of an electrically insulating material (25) arranged on the first and second lateral surfaces respectively, **characterised in that** the first and second lateral surfaces and the first and second portions of the electrically insulating material (25) arranged thereon are surrounded with a further electrically insulating material (23) for preventing short circuits between the electrodes (22) and in that the further electrically insulating material (23) is enveloped by a metal cover (31) to inhibit the ingress of moisture into the electro-distortion device and thus prevent degradation of electrical insulation between electrodes.

2. A device according to claim 1, wherein the metal cover (31) has been formed by vaporising the metal onto the further electrically insulating material (23).

3. A device according to claim 1 or 2, wherein the metal cover (31) is made of aluminium.

4. A device according to any one of the preceding claims, wherein the electro-distortive material is a piezoelectric ceramic material.

5. A device according to any one of the preceding claims, wherein the further electrically insulating material (23) comprises an epoxy resin.

6. A device according to any one of the preceding claims, wherein the electrically insulating material (25) is a glass.

7. A device according to any one of the preceding claims, wherein the first and second portions of electrically insulating material (25) are formed as beads.

8. A dot-matrix printing head comprising a plurality of dot printing devices (30), each having an electro-distortion device (3) according to any one of the preceding claims, wherein, for each such dot printing device, one end of the stack is rigidly secured to a base member (1) and the other end of the stack is in force-transmitting engagement with a movable member (11) at an actuating position (A) thereof located part way along its length, wherein the movable member extends from one side of the actuating position (A) to a fixing position (B) at which it is fixed to the base member (1) and, from the other side of the actuating position (A), to a printing dot position where a dot-printing member (4) is arranged thereon.

## Patentansprüche

1. Elektroverformungsvorrichtung, umfassend wenigstens erste, zweite und dritte Schichten (21), die elektroverformbares Material umfassen, mit mindestens einer ersten Elektrode (22), welche erste Elektrode (22) zwischen die erste Schicht und die zweite Schicht zwischengelegt ist, und mindestens einer zweiten Elektrode (22), welche zweite Elektrode (22) zwischen die zweite Schicht und die dritte Schicht (23) zwischengelegt ist, bei der die Schichten und Elektroden in einem Stapel angeordnet sind, der sich entlang einer Stapelachse erstreckt und eine erste seitliche Oberfläche und eine zweite seitliche Oberfläche hat, welche erste Elektrode und zweite Elektrode elektrisch mit einer ersten bzw. einer zweiten von außen zugänglichen Verbindungseinrichtung (24a, 24b) über die erste bzw. die zweite seitliche Oberfläche verbunden sind, so daß eine elektrische Potentialdifferenz, die an die erste und die zweite von außen zugängliche Verbindungseinrichtung (24a, 24b) angelegt wird, eine Veränderung in der Ausdehnung des Stapels entlang seiner Stapelachse bewirkt, welche erste Elektrode oder Elektroden und zweite Elektrode oder Elektroden elektrisch voneinander durch mindestens einen ersten Abschnitt und mindestens einen zweiten Abschnitt eines elektrisch isolierenden Materials (25) isoliert sind, das an der ersten bzw. der zweiten seitlichen Oberfläche angeordnet ist, dadurch gekennzeichnet, daß die erste und die zweite seitliche Oberfläche und der erste und der zweite Abschnitt des elektrisch isolierenden Materials (25), das auf diesen angeordnet ist, mit einem weiteren elektrisch isolierenden Material (23) umgeben sind, um Kurzschlüsse zwischen den Elektroden (22) zu verhindern, und dadurch, daß das weitere elektrisch isolierende Material (23) durch eine Metallabdeckung (31) umhüllt ist, um das Eindringen von Feuchtigkeit in die Elektroverformungsvorrichtung zu verhindern und somit die Verschlechterung einer elektrischen Isolierung zwischen den Elektroden zu vermeiden.

2. Vorrichtung nach Anspruch 1, bei welcher die Metallabdeckung (31) durch Aufdampfen des Metalles auf das weitere elektrisch isolierende Material (23) gebildet wurde.

3. Vorrichtung nach Anspruch 1 oder 2, bei welcher die Metallabdeckung (31) aus Aluminium hergestellt ist.

4. Vorrichtung nach einem der vorstehenden Ansprüche, bei welcher das elektroverformbare Material ein piezoelektrisches Keramikmaterial ist.

5. Vorrichtung nach einem der vorstehenden Ansprüche, bei welcher das weitere elektrisch isolierende Material (23) ein Epoxyharz umfaßt.

6. Vorrichtung nach einem der vorstehenden Ansprüche, bei welcher das elektrisch isolierende Material (25) ein Glas ist.

7. Vorrichtung nach einem der vorstehenden Ansprüche, bei welcher der erste und der zweite Abschnitt des elektrisch isolierenden Materials (25) als Perlen ausgebildet sind.

8. Punktmatrixdruckkopf, umfassend eine Vielzahl von Punktdruckvorrichtungen (30), von welchen jede eine Elektroverformungsvorrichtung gemäß einem der vorstehenden Ansprüche hat, bei welcher für jede derartige Punktdruckvorrichtung ein Ende des Stapels starr an einem Basiselement (1) befestigt ist und das andere Ende des Stapels in kraftübertragendem Eingriff mit einem beweglichen Element (1) an einer Betätigungsposition (A) desselben steht, die an einer Teilstrecke entlang dessen Länge angeordnet ist, bei welcher sich das bewegliche Element von einer Seite der Betätigungsposition (A) zu einer Befestigungsposition (B) erstreckt, an welcher es an dem Basiselement (1) befestigt ist, und von der anderen Seite der Betätigungsposition (A) zu einer Druckpunktposition, wo ein Punktdruckelement (4) auf diesem angeordnet ist.

## Revendications

1. Dispositif à déformation électrique comprenant au moins un premier, un second et un troisième feuillet (21) constitués d'un matériau à déformation électrique, avec au moins une première électrode (22), la première électrode (22) étant placée entre le premier et le second feuillet, et au moins une seconde électrode (22), la seconde électrode (22) étant disposée entre le second et le troisième feuillet (21), les feuillets et les électrodes étant disposés dans un empilement placé le long d'un axe d'empilement et ayant une première surface latérale et une seconde surface latérale, la première et la seconde électrode étant connectées électriquement à un premier et un second dispositif de connexion (24a, 24b) respectivement, accessibles depuis l'extérieur, par l'intermédiaire de la première et de la seconde surface latérale respectivement, afin qu'une différence de potentiel électrique appliquée au premier et au second dispositif de connexion (24a, 24b) qui sont accessibles depuis l'extérieur provoque un changement de la longueur de l'empilement le long de l'axe d'empilement, la première ou les premières électrodes et la seconde ou les secondes électrodes étant isolées électriquement les unes des autres par au moins une première partie et au moins une seconde partie d'un matériau isolant de l'électricité (25) disposées sur la première et la seconde surface latérale respectivement, caractérisé en ce que la première et la seconde surface latérale et la première et la seconde partie du matériau isolant de l'électricité (25) placées sur les surfaces sont entourées d'un matériau isolant de l'électricité supplémentaire (23) destiné à empêcher la formation de courts-circuits entre les électrodes (22), et en ce que le matériau isolant de l'électricité supplémentaire (23) est enveloppé par un couvercle métallique (31) destiné à empêcher l'entrée d'humidité dans le dispositif à déformation électrique et empêche ainsi la dégradation de l'isolement électrique entre les électrodes.

2. Dispositif selon la revendication 1, dans lequel le couvercle métallique (31) a été formé par vaporisation du métal sur le matériau isolant de l'électricité supplémentaire (23).

3. Dispositif selon la revendication 1 ou 2, dans lequel le couvercle métallique (31) est formé d'aluminium.

4. Dispositif selon l'une quelconque des revendications précédentes, dans lequel le matériau à déformation électrique est un matériau céramique piézoélectrique.

5. Dispositif selon l'une quelconque des revendications précédentes, dans lequel le matériau isolant de l'électricité supplémentaire (23) est une résine époxyde.

6. Dispositif selon l'une quelconque des revendications précédentes, dans lequel le matériau isolant de l'électricité (25) est un verre.

7. Dispositif selon l'une quelconque des revendications précédentes, dans lequel la première et la seconde partie du matériau isolant de l'électricité (25) sont formées par des cordons.

8. Tête d'impression matricielle comprenant plusieurs dispositifs (30) d'impression de point, ayant chacun un dispositif (3) à déformation électrique selon l'une quelconque des revendications précédentes, dans lequel, pour chaque dispositif d'impression de point, une première extrémité de l'empilement est fixée rigidement à un organe de base (1) et l'autre extrémité d'empilement est en coopération permettant une transmission de force avec un organe mobile (11) à une position de manoeuvre (A) placé partiellement suivant sa longueur, et l'organe mobile est disposé d'un côté de la position de manoeuvre (A) vers une position de fixation (B) à laquelle il est fixé à l'organe de base (1) et, de l'autre côté de la position de manoeuvre (A), vers une position d'impression d'un point à laquelle est placé un organe (4) d'impression d'un point.
